(19)

Europäisches
Patentamt

European
Patent Office

Office européen
des brevets

(11)  EP 2 201 675 B1

(12)  **EUROPEAN PATENT SPECIFICATION**

(45) Date of publication and mention
of the grant of the patent:
**08.01.2020  Bulletin 2020/02**

(51) Int Cl.:
***H03H 21/00*** *(2006.01)*

(21) Application number: **08836359.3**

(86) International application number:
**PCT/US2008/011334**

(22) Date of filing: **30.09.2008**

(87) International publication number:
**WO 2009/045414 (09.04.2009 Gazette 2009/15)**

(54) **SYSTEM AND METHOD FOR ADAPTIVE NONLINEAR FILTERING**

SYSTEM UND VERFAHREN FÜR ADAPTIVE NICHTLINEARE FILTERUNG

SYSTÈME ET PROCÉDÉ POUR UN FILTRAGE NON LINÉAIRE ADAPTATIF

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **04.10.2007  US 998057 P**

(43) Date of publication of application:
**30.06.2010  Bulletin 2010/26**

(73) Proprietor: **Avago Technologies International
Sales
Pte. Limited
Singapore 768923 (SG)**

(72) Inventor: **BATRUNI, Roy, G.
Fremont, CA 94538 (US)**

(74) Representative: **Bosch Jehle
Patentanwaltsgesellschaft mbH
Flüggenstraße 13
80639 München (DE)**

(56) References cited:
**JP-A- H07 141 776        US-A- 5 775 293
US-A1- 2002 169 585    US-A1- 2004 164 791
US-A1- 2004 263 367    US-A1- 2005 201 457
US-A1- 2006 061 493    US-A1- 2006 215 064**

EP 2 201 675 B1

**Description**

CROSS REFERENCE TO OTHER APPLICATIONS

This application claims priority to U.S. Provisional Patent Application No. 60/998,057 entitled CANONICAL NONLINEAR FILTER filed October 4, 2007.

BACKGROUND OF THE INVENTION

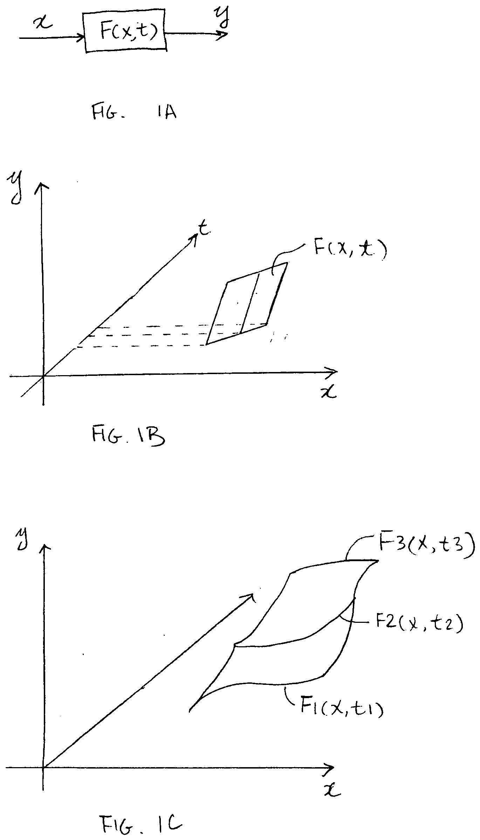

FIG. 1A is a block diagram illustrating a signal model of a typical system. An input x is sent to system 100, which applies a function F to x to generate an output y. Since it is possible for the function to vary over time, F is also dependent on time t. In many systems, it is desirable for the system function $F(x, t)$ to be linear. FIG. 1B is a three-dimensional (3-D) diagram illustrating a linear relationship between the input x, the output y, and time t. In this ideal case the input and the output have a linear relationship that is constant throughout time t. Thus, function $y = F(x, t)$ forms a plane in the 3-D diagram.
It is common, however, for the system to be nonlinear. There are many possible causes for system nonlinearities, including characteristics of nonlinear components (such as conductors, capacitors and transistors), the input signal's frequency subrange, history and rate of change (also referred to "slew rate"), as well as external factors such as operating temperature. FIG. 1C is a 3-D diagram illustrating a typical nonlinear relationship. In this example, not only is the relationship between input x and output y nonlinear, this nonlinear relationship changes over time, as illustrated by sample functions $F1(x, t1)$, $F2(x, t2)$, and $F3(x, t3)$. Thus, the function $y = F(x, t)$ forms a nonlinear manifold. It is often useful to have filters that can implement this type of nonlinear functions. Many existing nonlinear filters, however, are complex, expensive, and unstable.
US 2005/201457 A1 discloses systems and methods for very high throughput adaptive filtering using distributed arithmetic.

SUMMARY OF THE INVENTION

The problems mentioned above with respect to the prior art are solved by an adaptive nonlinear filtering system according to claim 1 and an adaptive nonlinear processing method according to claim 16.

BRIEF DESCRIPTION OF THE DRAWINGS

Various embodiments of the invention are disclosed in the following detailed description and the accompanying drawings.

FIG. 1A is a block diagram illustrating a signal model of a typical system.

FIG. 1B is a three-dimensional (3-D) diagram illustrating a linear relationship between the input x, the output y, and time t.

FIG. 1C is a 3-D diagram illustrating a typical nonlinear relationship.

FIG. 2 is a block diagram illustrating an embodiment of a nonlinear adaptive filter.

FIG. 3 is a diagram illustrating in greater detail an example implementation of memory banks 206a-206d of FIG. 2.

FIG. 4A is a block diagram illustrating another embodiment of a simplified adaptive nonlinear filter.

FIG. 4B is a diagram illustrating in greater detail an example implementation of memory banks 406a-406d of FIG. 4A.

FIG. 5 is a flowchart illustrating an embodiment of a process for operating an adaptive nonlinear filter.

FIG. 6 is a block diagram illustrating an embodiment of a cascaded nonlinear filter.

FIG. 7 is a block diagram illustrating another embodiment of an adaptive nonlinear filter.

FIGS. 8 and 9 are block diagrams illustrating embodiments of adaptive nonlinear filters that handle even and odd harmonic distortions, respectively.

FIGS. 10A-10C are block diagrams illustrating several example applications that employ nonlinear adaptive filters.

## DETAILED DESCRIPTION

A detailed description of one or more embodiments of the invention is provided below along with accompanying figures that illustrate the principles of the invention. The invention is described in connection with such embodiments, but the invention is not limited to any embodiment. The scope of the invention is limited only by the claims and the invention encompasses numerous alternatives, modifications and equivalents. Numerous specific details are set forth in the following description in order to provide a thorough understanding of the invention. These details are provided for the purpose of example and the invention may be practiced according to the claims without some or all of these specific details. For the purpose of clarity, technical material that is known in the technical fields related to the invention has not been described in detail so that the invention is not unnecessarily obscured.

A nonlinear adaptive filter is disclosed. The nonlinear adaptive filter includes interfaces for receiving an input signal and a target signal. It further includes an adaptive filter module that is configured to generate relative location information pertaining to a relative location of the input signal within a possible range of inputs. A thermometer code address generator is used to generate the relative location information. The relative location information is used to determine input dependent filter parameters. The relative location information includes a thermometer coded address vector, which is used to select input dependent filter parameters from a plurality of memory banks. In some embodiments, the input dependent filter parameters include filter coefficients that are used to generate an output signal. A feedback signal is generated based at least in part on an output signal and the target signal. Stored input dependent filter parameters are adapted based on the feedback signal.

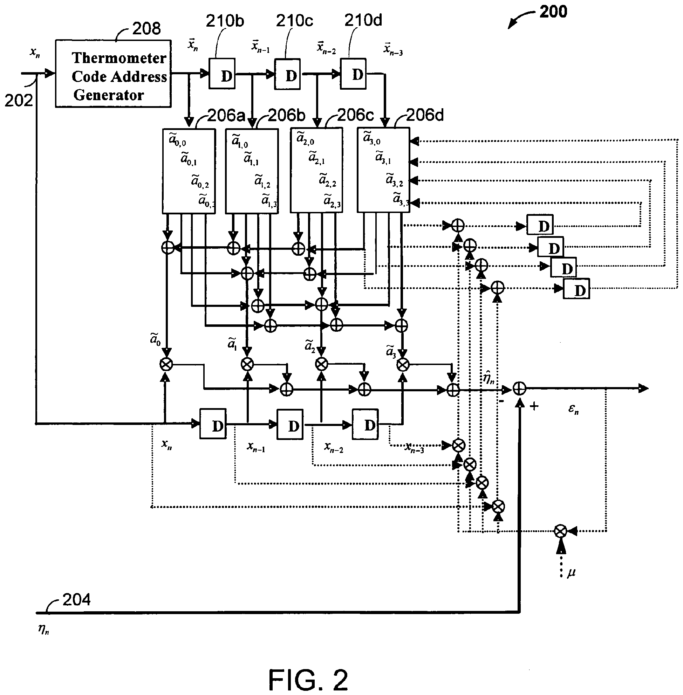

FIG. 2 is a block diagram illustrating an embodiment of a nonlinear adaptive filter. In this example, nonlinear adaptive filter 200 implements a nonlinear filter function expressed as:

$$y_n = \tilde{a}_0(X_n) x_n + \tilde{a}_1(X_n) x_{n-1} + \cdots + \tilde{a}_{N-1}(X_n) x_{n-N+1} \qquad [1]$$

where $X_n = [x_n \cdots x_{n-N+1}]$.

The above nonlinear filter function has filter taps with coefficients $\tilde{a}_k$ that depend on the present input sample as well as previous input samples. In some embodiments, each coefficient is implemented as a constant plus a nonlinear function of the signal. As will be discussed in detail below, these coefficients are adaptable to achieve the desired filter response, such as a filter response that is a nonlinear function.

An alternative expression for equation [1] is:

$$y_n = \left[ \tilde{A}_0(x_n) + \tilde{A}_1(x_{n-1}) + \cdots + \tilde{A}_{N-1}(x_{n-N+1}) \right] X_n = \left[ \sum_{j=0}^{N-1} \tilde{A}_j(x_{n-j}) \right] X_n \quad [2]$$

$$= \tilde{A}_n(X_n) X_n$$

where $\tilde{A}_j(x_{n-j}) = [\tilde{a}_{j,0}(x_{n-j})\ \tilde{a}_{j,1}(x_{n-j}) \cdots \tilde{a}_{j,N-1}(x_{n-j})]$.

The above equations indicate that each filter tap coefficient can be expressed as a sum of sub-taps (i.e. $\sum_{j=0}^{N-1} \tilde{A}_j(x_{n-j})$), and each sub-tap $\tilde{A}_j(x_{n-j})$ in turn is a different function of $x_{n-j}$. Equivalently, the coefficient of the k-th filter tap can be expressed as:

$$\tilde{a}_k(X_n) = \left[ \sum_{j=0}^{N-1} \tilde{a}_{j,k}(x_{n-j}) \right]. \qquad [3]$$

Returning to FIG. 2, nonlinear adaptive filter 200 includes a first input interface 202 on which an input digital signal $x_n$ is received, and a second input interface 204 on which the target signal $\eta_n$ is received. As will be discussed in greater detail below, the filter adapts its coefficients so that its output $\hat{\eta}_n$ tracks the target signal $\eta_n$. In other words, the filter adapts until the difference between its output is $\hat{\eta}_n$ and the target signal $\eta_n$ is within a predefined value.

The values of filter coefficients $\tilde{a}_0$, $\tilde{a}_1$, $\tilde{a}_2$, and $\tilde{a}_3$ each depend on the present input sample as well as past input samples (sometimes also referred to as delayed input samples or the input signal's history). The coefficient values are computed based at least in part on sums of selected, pre-stored values. In this example, the values are selected from appropriate storage locations within a plurality of memory banks. System 200 includes memory banks 206a, 206b, 206c, and 206d that correspond to filter taps 0, 1, 2, and 3, respectively. Although four memory banks are shown for purposes of example, the number of memory banks depends on the number of filter taps N and may vary in other embodiments. The memory banks may be implemented using one or more memory devices of any appropriate type, such as registers, buffers, DRAM, SRAM, etc. The memory banks represent the logical organization of memory used to store filter parameters. In some embodiments, the memory banks are implemented using M physical memory devices where M does not necessarily correspond to N. For example, all four memory banks shown in system 200 may be implemented using a single memory device such as a single EEPROM or RAM chip.

According to this example, each memory bank stores N sets of values (N = number of taps) that contribute to the N filter coefficients. Each set of values is implemented as a coefficient vector that includes S entries. The value of S depends on the granularity or precision of the nonlinear function being implemented. For example, if the nonlinear function is such that for all input values $\beta_{min} < x_{n-j} \leq \beta_0$ (where $\beta_{min}$ is the minimum expected input value, and $\beta_0$ is a predefined value), coefficient function $\tilde{A}_{n-j}(x_{n-j})$ maps to one set of vector values, and for all input values $\beta_0 < x_{n-j} < \beta_{max}$ (where $\beta_{max}$ is the maximum expected input value), the coefficient function maps to another set of vector values, then the coefficient function is said to have a granularity of 2 and each set of coefficient vector includes two entries. In the example shown in FIG. 2, the possible inputs are divided into four subranges $\beta_{min} < x_{n-j} \leq \beta_0$, $\beta_0 < x_{n-j} \leq \beta_1$, and $\beta_1 < x_{n-j} \leq \beta_2$, and $\beta_2 < x_{n-j} \leq \beta_{max}$, which map to four possible coefficient vectors $\tilde{a}_{n-j,0}$, $\tilde{a}_{n-j,1}$, $\tilde{a}_{n-j,2}$, and $\tilde{a}_{n-j,3}$, respectively. Thus, the coefficient function has a granularity of 4 and A memory bank therefore stores 4 coefficient vectors $\tilde{a}_{n-j,0}$, $\tilde{a}_{n-j,1}$, $\tilde{a}_{n-j,2}$, and $\tilde{a}_{n-j,3}$. More generally, if all the possible input values are divided into S subranges and each input subrange maps to a corresponding coefficient vector (i.e., a granularity of S), then each vector in the memory bank stores S entries.

A thermometer code address generator 208 is used to facilitate the selection of the appropriate coefficient vector from the memory banks. The thermometer code address generator indicates the relative location of the input signal within the range of possible input signals. In some embodiments, the thermometer code address generator includes one or more comparators that compare the input with certain predefined subranges, and one or more multiplexers that map the output of the comparators to an appropriate address vector. The address vector indicates the relative location of the input signal within the possible input range. In some embodiments, the address vector has at most one sign change between any two adjacent entries.

The thermometer code address generator is configured to divide the possible range of inputs $\vec{\beta} = \{\beta_{min}, \beta_{max}\}$ into S subsubranges. The values in these subsubranges may be distributed evenly, logarithmically, exponentially, or in any other appropriate ways. Upon receiving an input value $x_{n-j}$, the thermometer code address generator applies the following coding function to generate the appropriate output vector:

$$\vec{x}_{n-j} = Sign\left( x_{n-j} - \vec{\beta} \right) \tag{4}$$

Based on the thermometer coder output, the set of values that corresponds to the fist positive location in vector $\vec{x}_{n-j}$ is selected from the memory bank. The output of the thermometer code address generator is delayed by delay blocks 210b, 210c, and 210d. The delayed values are used to select the appropriate stored coefficient vectors from corresponding memory banks. At each filter tap $n-j$, selected values from the filter banks (the "sub-taps") are summed to generate the corresponding coefficient value $\tilde{a}_{n-j}$. In some alternative embodiments, the thermometer code address generator directly determines which coefficient values in the memory bank should be selected.

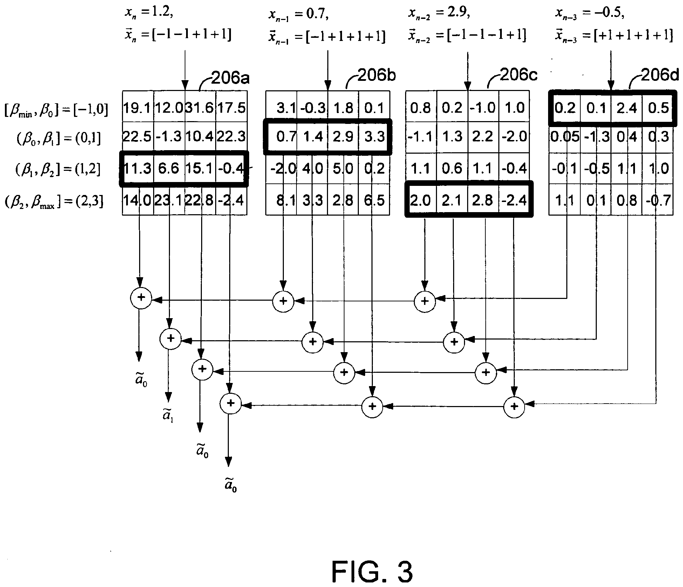

FIG. 3 is a diagram illustrating in greater detail an example implementation of memory banks 206a-206d of FIG. 2. The figure gives a numerical example of how to compute coefficients $\tilde{a}_{n-j}$. In this example, memory banks 206a-206d are implemented as four 4x4 matrices. Other implementations are possible in other embodiments. Four rows of the matrices map to 4 input subranges, which are [-1, 0], (0, 1], (1, 2], and (2, 3]. Each row is a vector with 4 entries. In this example, $x_n = 1.2$, which falls in the subrange of (1, 2], and corresponds to a thermometer code address generator output of [-1 -1 +1 +1]. Thus, $\tilde{a}_{0,2}$, the third row from memory bank 206a, is selected. Similarly, given $x_{n-1} = 0.7$, $x_{n-2} = 2.9$, and $x_{n-3} = -0.5$, the corresponding thermometer code address generator outputs are $\vec{x}_{n-1} = [-1+1+1+1]$, $\vec{x}_{n-2} = [-1-1-1+1]$, and $\vec{x}_{n-3} = [+1+1+1+1]$, respectively. The second row of memory bank 206b ($\tilde{a}_{1,1}$), the last row of memory bank 206c ($\tilde{a}_{2,3}$), and the first row of memory bank 206d ($\tilde{a}_{3,0}$) are selected accordingly.

To generate a filter coefficient for a filter tap, the corresponding entries from the selected rows are summed.

In this example, the 0-th entries of the selected rows (i.e., 11.3, 0.7, 2.0, 0.2) are the values selected and summed to generate coefficient $\tilde{a}_0$ for the tap 0. Similarly, 6.6, 1.4, 2.1, and 0.1 are the values selected and summed to generate coefficient $\tilde{a}_1$, for tap 1, and so on.

Returning to FIG. 2, the input samples are multiplied with the filter coefficients, generating a filter output which expressed as:

$$y_n = \hat{\eta}_n = \sum_{j=0}^{N-1} \tilde{a}_j x_{n-j} \qquad [5]$$

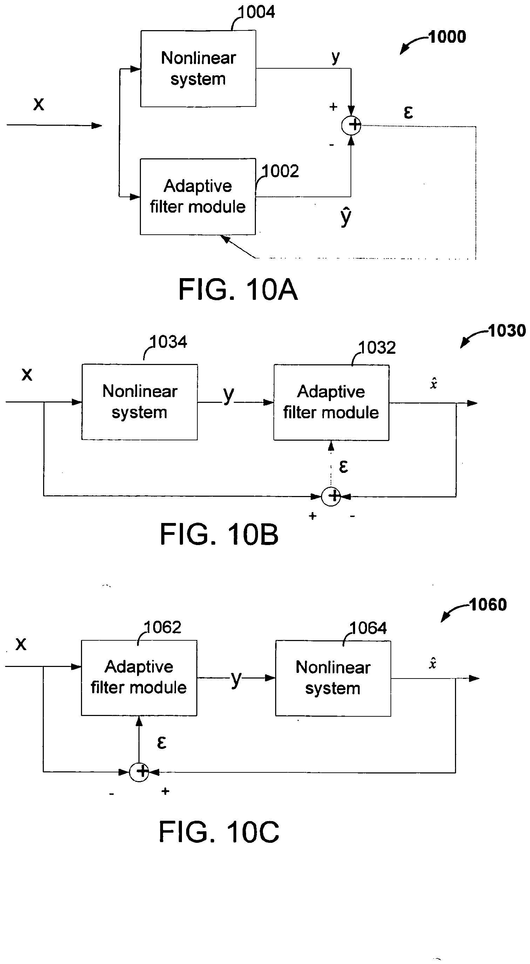

A target signal $\eta_n$ is received on interface 204. How the target signal is obtained depends on system configuration and is described in greater detail in FIGS. 10A-10C below. In example system 200, the output is subtracted from a target signal $\eta_n$ to obtain an error $\varepsilon_n$. The input signal is multiplied with the error as well as an update coefficient $\mu$, and the result is fed back to adapt the filter coefficients. In some embodiments, the initial value of $\mu$ is arbitrarily selected. During the adaptation process, $\mu$ is continuously adjusted to adapt the filter coefficients and reduce output error, according to techniques such as least mean squared error (LMSE). The update function of adaptive filter 200 is expressed as:

$$\tilde{A}_j\left(\vec{X}_n\right) = \tilde{A}_j\left(\vec{X}_n\right) + \mu\,\varepsilon_n\,X_n \qquad [6]$$

where

$$\vec{X}_n = \left[\begin{array}{cccc} \vec{x}_n & \vec{x}_{n-1} & \cdots & \vec{x}_{n-N+1} \end{array}\right]$$

are the thermometer-coded values of the input signals.
In effect this means

$$\tilde{a}_{j,k}\left(\vec{x}_{n-j}\right) = \tilde{a}_{j,k}\left(\vec{x}_{n-j}\right) + \mu\,\varepsilon_n\,x_{n-k}$$

where the update to memory bank j column k at address indexed by $\vec{x}_{n-j}$ is a function of the error $\varepsilon_n$ multiplied by the signal $x_{n-k}$ to which the output of this column had contributed in forming the coefficient $\tilde{a}_{j,k}(\vec{x}_{n-j})$.

The feedback loop for coefficients stored in memory bank 206d is illustrated in detail in FIG. 2. In the feedback loop shown, input samples $x_n$, $x_{n-1}$, $x_{n-2}$, and $x_{n-3}$ are each multiplied with $\mu\,\varepsilon_n$. The results are delayed and added to the coefficient vector in memory bank 206d that is currently selected based on the current memory location of $\vec{x}_{n-3}$. Referring to the detailed implementation example shown in FIG. 3, the values in row [0.2 0.1 2.4 0.5] are updated based on the results of update function [6]. Similarly, the values in other selected rows of the other memory banks are also updated, although the feedback loops are omitted to keep the diagram clear. In the following discussion, the feedback loops are sometimes omitted from the figures even though in practice the feedback loops are included and the same principles of feedback and update apply.

A filter system similar to 200 is a cost effective way of implementing the theoretically optimal Volterra series expansion and as well as Weiner-Hammerstein models that include memory dispersion. In some embodiments, a filter with N taps is used, where each tap k has the form of equation [3], i.e., the coefficient function

$$\tilde{a}_k\left(X_n\right) = \left[\sum_{j=0}^{N-1} \tilde{a}_{j,k}\left(x_{n-j}\right)\right],$$

in which $\tilde{a}_{j,k}(x_{n-j})$ is an arbitrarily complex nonlinear function of the variable $x_{n-j}$. Using Volterra series expansion, $\tilde{a}_{j,k}(x_{n-j})$ can be expressed to arbitrary precision using an $m^{th}$ order polynomial of $x_{n-j}$. Similarly, all the $x_{n-j}$'s in tap k (where j=0, 1, ... N-1) can also be expressed to arbitrary precision. For example, the coefficient $\tilde{a}_{j-k}(x_{n-j})$ can be written as a $5^{th}$ order polynomial

$$\tilde{a}_{j,k}\left(x_{n-j}\right) = x_n + x_n^2 + x_n^3 + x_n^4 + x_n^5 \qquad [7]$$

where the weights of the coefficients are assumed to be 1 for the sake of simplicity but may vary in practice. Accordingly,

$$\tilde{a}_k(X_n) = x_n + x_n^2 + x_n^3 + x_n^4 + x_n^5 +$$
$$x_{n-1} + x_{n-1}^2 + x_{n-1}^3 + x_{n-1}^4 + x_{n-1}^5 +$$
$$\vdots$$
$$x_{n-N+1} + x_{n-N+1}^2 + x_{n-N+1}^3 + x_{n-N+1}^4 + x_{n-N+1}^5 \qquad [8]$$

The $k^{th}$ coefficient $\tilde{a}_k(X_n)$ expressed as equation [8] is multiplied by $x_{n-k}$, forming a polynomial with cross terms comprising $x_{n-k-j}$ multiplied with $x_{n-k}$ for j=0, 1, ..., N-1. Thus, the nonlinear function is a true Volterra expansion of arbitrarily high degree and has memory. For example, when k = 0, the function includes all cross terms of $x_n$, and for k = 1 the function includes all cross terms of $x_{n-1}$, and so on.

In some embodiments, rather than storing all the coefficients in memory, filter coefficient functions including construction functions such as Radial Basis Functions (RBF), cubic splines, or sinc functions are used to provide the coefficients. The construction functions include windowed interpolation functions that use weighting coefficients and distance from function origins to generate interpolation values. In a construction function, discrete sample values are summed to generate a smoothed approximation of a background function and values between sample points. The general format for a construction function is:

$$v(x) = \sum_{i=1}^{L} w_i \, \Phi\left( \| x - c_i \| \right) \qquad [9]$$

where $c_i$ are the centers of the RBF and $w_i$ are the coefficients.

An example of a RBF is:

$$v_n(x) = \sum_{i=1}^{L} w_i \, Exp\left( -\gamma \, \| x_n - c_i \| \right) = W_n \, E_n^T$$

where $\gamma$ is a constant that determines the shape of the RBF. The coefficients are adapted according to the following:

$$W_{n+1} = W_n + \mu \, \varepsilon_n \, E_n$$

where $W_n = \llbracket w_{1,n} \cdots w_{L,n} \rrbracket$ and $E_n = [Exp(-\gamma \| x_n - c_1 \|) \cdots Exp(-\gamma \| x_n \_ c_L \, x_n - c_L \|)]$

Thus, the filter can be implemented using RBF components instead of implementing the polynomial of equation [7] as an actual polynomial structure or storing the coefficients in a lookup table. This implementation allows for tradeoffs be made between the amount of memory and the number of multiplications required. For example, let

$$\tilde{a}_{j,k}(x_{n-j}) = x_n + x_n^2 + x_n^3 + x_n^4 + x_n^5 = \sum_{i=1}^{L} w_i \, Exp\left( \| x_n - c_i \| \right) \qquad [10]$$

In some embodiments, the number of centers L is chosen depending on the desired accuracy and the multiplication requirements.

Note that when a signal $x$ lies on the center $c$, the coefficient $w$ corresponds to what is stored in memory since $Exp(\| x_n - c_i \|) = 1$. This means that a RBF can be used in conjunction with stored values to provide interpolation between quantization levels of $x$. Since only a few adjacent locations contribute to the interpolated result at $x$, the amount of processing required by the RBF in this case is less than if no stored values were used.

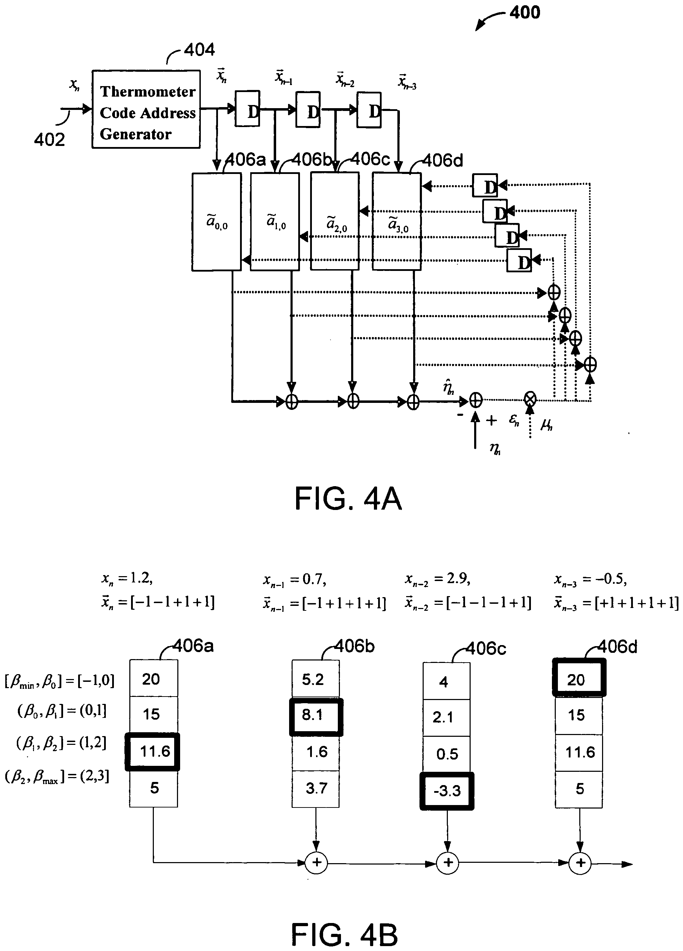

In an N-tap filter embodiment similar to filter 200 described above, the output is obtained with a convolution function that requires N multiplications. The number of multiplications can be reduced in some embodiments by simplifying the expression for the coefficients. FIG. 4A is a block diagram illustrating another embodiment of a simplified adaptive nonlinear filter. In simplified filter 400, each tap k corresponds to a polynomial function of the signal $x_{n-j}$ without multiplication with other cross terms. The simplified filter structure is expressed as:

$$\tilde{A}(X_n) = \left[ \tilde{a}_{0,0}(x_n) \; \tilde{a}_{1,0}(x_{n-1}) \; \cdots \; \tilde{a}_{N-1,0}(x_{n-N+1}) \right] \qquad [11].$$

The output is expressed as:

$$y_n = \tilde{a}_{0,0}(x_n) + \tilde{a}_{1,0}(x_{n-1}) + \cdots + \tilde{a}_{N-1,0}(x_{n-N+1}) \qquad [12].$$

In other words, each filter tap k implements a corresponding function $\tilde{a}_k$ of $x_{n-k}$. Filter function [12] does not require any multiplication and is computationally inexpensive. To implement the filter, the possible range of inputs $\vec{\beta} = \{\beta_{min}, \beta_{max}\}$ is divided into S subranges based on the desired function granularity/precision. Each input subrange k maps to a corresponding function $\tilde{a}_k (x_{n-k})$. Rather than storing vectors that correspond to the subranges as was shown in FIG. 3, memory banks 406a-d in this example store functions that correspond to the subranges. For example, if there are 4 subranges, then 4 values of the functions $\tilde{a}_{k,0} (x_{n-k,0})$, $\tilde{a}_{k,0} (x_{n-k,1})$, $\tilde{a}_{k,0} (x_{n-k,2})$, and $\tilde{a}_{k,0} (x_{n-k,3})$ are stored in the k-th memory bank.

The input $x_n$ received on input interface 402 is sent to a thermometer code address generator 404, which generates an appropriate output vector according to equation [4]. The vector is used to locate a value $\tilde{a}_{0,0} (x_{n,j0})$ in memory bank 406a that maps to the input, where j0 depends on the subrange in which the input is located. Similarly, thermometer coded and delayed input samples are used to locate in memory banks 406b, 406c, and 406d function values $\tilde{a}_{1,0} (x_{n-1,j1})$, $\tilde{a}_{2,0} (x_{n-2,j2})$, and $\tilde{a}_{3,0} (x_{n-3,j3})$, respectively.

FIG. 4B is a diagram illustrating in greater detail an example implementation of memory banks 406a-406d of FIG. 4A. In the example show, memory banks 406a-406d are implemented as four 4x1 matrices. Values stored in rows that correspond to the thermometer coded input addresses are selected and summed.

Returning to FIG. 4A, the selected values are summed to generate output $\tilde{\eta}_n$. Since the function values are obtained by mapping the input to stored function values, multiplication is not required for generating the output. The output is subtracted from the target signal $\eta_n$ to obtain an error signal $\varepsilon_n$. The error signal is multiplied with update coefficient $\mu$, and the result is fed back to adapt the filter coefficients. The update function of the adaptive filter is expressed as:

$$\tilde{a}_{j,0}(x_{n-1}) = \tilde{a}_{j,0}(x_{n-1}) + \mu\,\varepsilon_n \qquad [13]$$

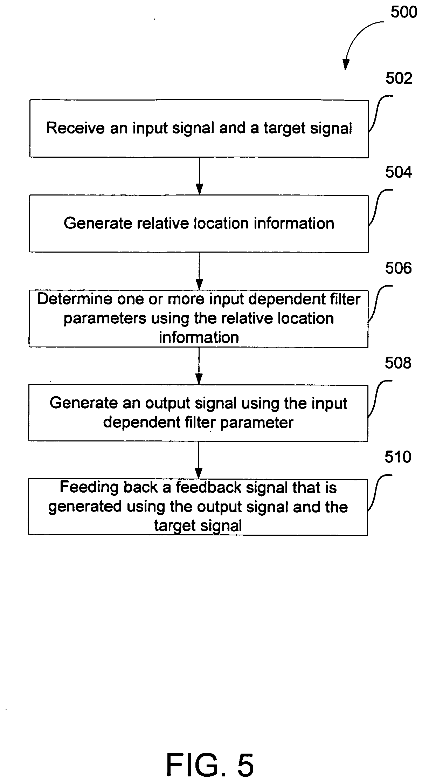

FIG. 5 is a flowchart illustrating an embodiment of a process for operating an adaptive nonlinear filter. Process 500 may be implemented on an adaptive filter system such as 200 or 400, as well as other embodiments discussed below. At 502, an input signal and a target signal are received. At 504, a relative location of the input signal within a range of possible inputs is determined. For example, in embodiments 200 and 400, a location vector is generated by the thermometer code address generator. The location vector indicates the relative location of the input signal, which corresponds to the subrange within which the input is located. At 506, one or more input dependent filter parameters are determined, using the relative location information of the input. For example, in embodiment 200, filter coefficients are computed using vectors selected from memory banks, based on the relative location of the input. In embodiment 400, functions $\tilde{a}_k (x_{n-k})$ or their mapped values are selected from memory banks, based on the relative location of the input.

At 508, an output signal is generated using the input dependent filter parameter. In embodiment 200, for example, the output signal is generated by multiplying the filter coefficients with the input samples and summing the results. In embodiment 400, the output signal is generated by summing results of the functions selected from the memory banks. At 510, a feedback signal is generated and fed back to the system. The feedback signal is based at least in part on the output signal and the target signal. In embodiment 200, the feedback signal is used to update the coefficients stored in the memory banks. In embodiment 400, the feedback signal is used to update the functions or function values stored in the memory banks.

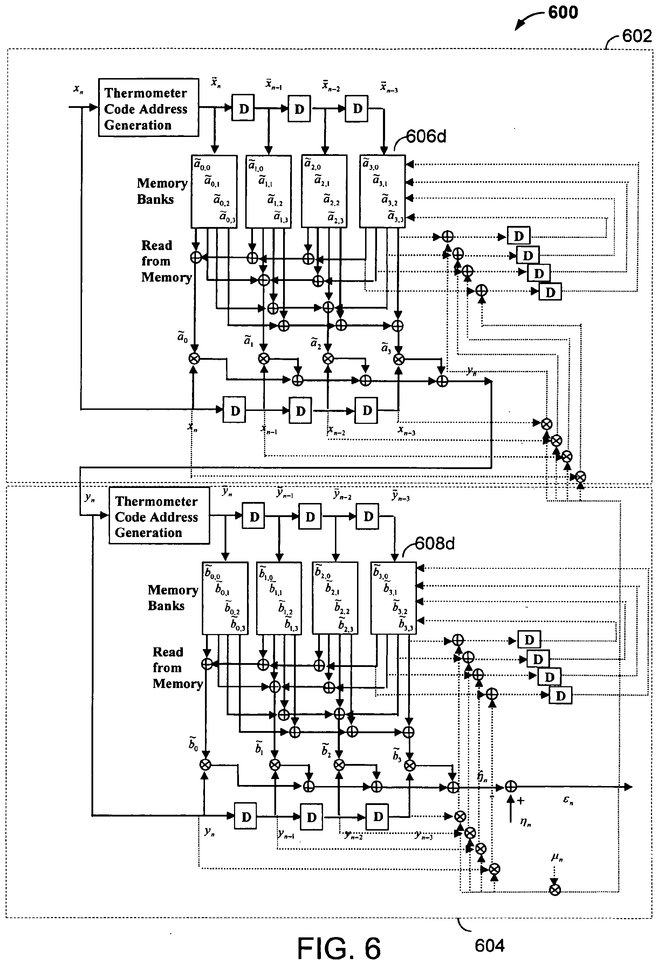

In some embodiments, multiple adaptive nonlinear filters are cascaded to form filter functions that are nonlinear functions of nonlinear functions. FIG. 6 is a block diagram illustrating an embodiment of a cascaded nonlinear filter. Adaptive nonlinear filter 600 includes a first adaptive nonlinear filter 602, whose output is sent to the input of a second adaptive nonlinear filter 604. In other embodiments, there may be more than two cascaded adaptive nonlinear filters.

Let filter 602 be expressed as:

$$y_n = \tilde{a}_0(X_n)x_n + \tilde{a}_1(X_n)x_{n-1} + \cdots + \tilde{a}_{N-1}(X_n)x_{n-N+1} \qquad [14]$$

where $X_n = [x_n \cdots x_{n-N+1}]$.

Filter 604 is expressed as:

$$w_n = \tilde{b}_0(Y_n) \, y_n + \tilde{b}_1(Y_n) \, y_{n-1} + \cdots + \tilde{b}_{N-1}(Y_n) \, y_{n-N+1} \qquad [15]$$

where $Y_n = [Y_n \cdots Y_{n-N+1}]$.

Thus,

$$w_n = \tilde{b}_0(Y_n) \, \tilde{A}_n \, X_n + \tilde{b}_1(Y_n) \, \tilde{A}_{n-1} \, X_{n-1} + \cdots + \tilde{b}_{N-1}(Y_n) \, \tilde{A}_{n-N+1} \, X_{n-N+1} \qquad [16]$$

$x_{n-j}$ in equation [16] corresponds to vector $\llcorner x_{n-j} \cdots x_{n-j-N+1} \lrcorner$, which has a length of N. The resulting cascaded filter function $w_n$ is a nonlinear function of $[x_n \cdots x_{n-2N+1}]$, which has a length of 2N-1. The cascaded filter of length 2N-1 requires less memory than a single uncascaded filter of length 2N. Suppose the input range is divided into S subranges, then 2NxS coefficients are required by a cascaded filter such as 600. In contrast, a single uncascaded filter of length 2N would require 2Nx2NxS coefficient entries. Thus, the cascade filter comprising two length-N filters requires ½ of the amount of memory required by an uncascaded length-2N filter. More generally, a cascaded filters comprising L filter taps requires 1/L as much memory as an uncascaded filter of approximately the same length.

The feedback loops of filters 602 and 604 are similar to the feedback loop shown in FIG. 2. Only the feedback loops of memory banks 606d and 608d are illustrated in the diagram and the feedback loops of other memory banks are not shown. The cascaded filter is adapted according to the following:

$$\tilde{b}_j(Y_n) = \tilde{b}_j(Y_n) + \mu \, \varepsilon_n \, y_{n-j} \qquad [17]$$

$$\tilde{a}_j(X_n) = \tilde{a}_j(X_n) + \mu \, \varepsilon_n \, x_{n-j} \qquad [18]$$

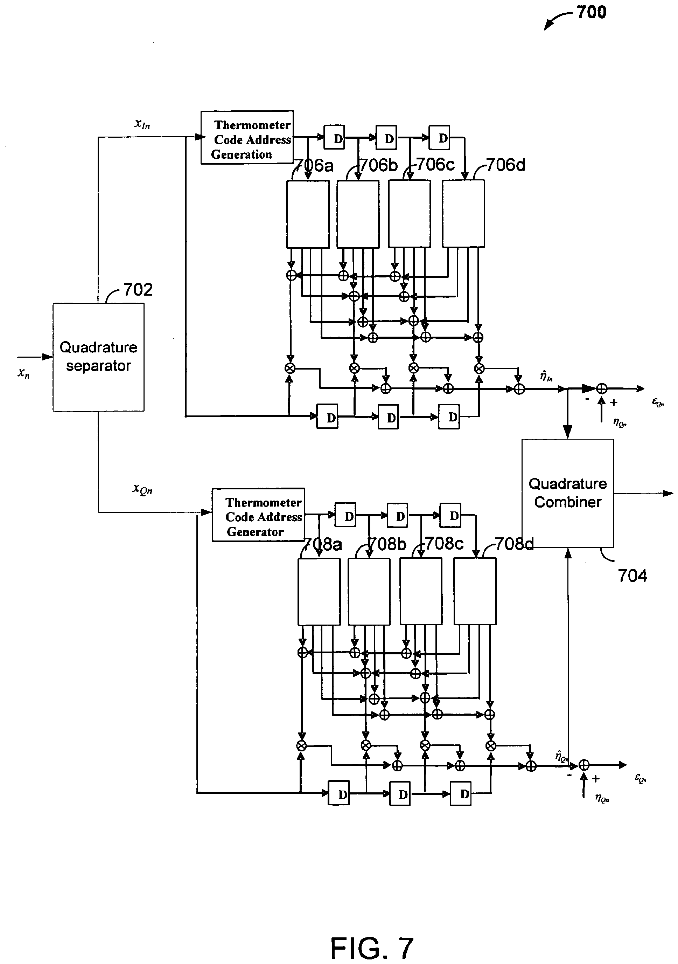

In some embodiments, an adaptive nonlinear filter is configured to handle complex signals. FIG. 7 is a block diagram illustrating another embodiment of an adaptive nonlinear filter. In this example, adaptive nonlinear filter 700 includes a quadrature separator 702 that separates the signal into in-phase (I) and quadrature phase (Q) components. The adaptive nonlinear filter 700 further includes two adaptive filter modules in a parallel configuration for processing the I and Q components. I and Q components are sent to their respective respective thermometer code address generators. The coded output for signal $x_{I\,n-j}$ is used as a memory address for selecting a vector $\tilde{A}_{I\,n-j}(x_{I\,n-j})$ from memory banks 706a-d. Similarly, the coded output for signal $x_{Q\,n-j}$ is used to select a vector $\tilde{A}_{Q\,n-j}(x_{Q\,n-j})$ from memory banks 708a-d. The outputs from I and Q branches $\hat{\eta}_{In}$ and $\hat{\eta}_{Qn}$ are combined by a quadrature combiner 704.

Filter 700 is expressed as:

$$
\begin{aligned}
y_{I\,n} &= \tilde{a}_{I0}(X_n)\,x_{In} + \tilde{a}_{I1}(X_{n-1})\,x_{I\,n-1} + \cdots + \tilde{a}_{I\,N-1}(X_{n-N+1})\,x_{I\,n-N+1} \\
&\quad + \tilde{a}_{Q0}(X_n)\,x_{Qn} + \tilde{a}_{Q1}(X_{n-1})\,x_{Q\,n-1} + \cdots + \tilde{a}_{Q\,N-1}(X_{n-N+1})\,x_{Q\,n-N+1} \\
&= \left[ \begin{array}{l} \tilde{A}_{I0}(x_{In}) + \tilde{A}_{I1}(x_{I\,n-1}) + \cdots + \tilde{A}_{I\,N-1}(x_{I\,n-N+1}) \\ + \tilde{A}_{Q0}(x_{Qn}) + \tilde{A}_{Q1}(x_{Q\,n-1}) + \cdots + \tilde{A}_{Q\,N-1}(x_{Q\,n-N+1}) \end{array} \right] X_n \qquad [19\mathrm{I}] \\
&= \left[ \sum_{j=0}^{N-1} \left( \tilde{A}_{I\,n-j}(x_{I\,n-j}) + \tilde{A}_{Q\,n-j}(x_{Q\,n-j}) \right) \right] X_n \\
&= \tilde{A}_{In}\,X_n
\end{aligned}
$$

and

$$y_{In} = \tilde{a}_{I0}(X_n)\, x_{Qn} + \tilde{a}_{I1}(X_{n-1})\, x_{Qn-1} + \cdots + \tilde{a}_{IN-1}(X_{n-N+1})\, x_{Qn-N+1}$$
$$\quad - \tilde{a}_{Q0}(X_n)\, x_{In} - \tilde{a}_{Q1}(X_{n-1})\, x_{In-1} - \cdots - \tilde{a}_{QN-1}(X_{n-N+1})\, x_{In-N+1}$$

$$= \begin{bmatrix} \tilde{A}_{I0}(x_{Qn}) + \tilde{A}_{I1}(x_{Qn-1}) + \cdots + \tilde{A}_{IN-1}(x_{Qn-N+1}) \\ -\tilde{A}_{Q0}(x_{In}) - \tilde{A}_{Q1}(x_{In-1}) - \cdots - \tilde{A}_{QN-1}(x_{In-N+1}) \end{bmatrix} X_n \qquad [19Q]$$

$$= \left[ \sum_{j=0}^{N-1} \left( \tilde{A}_{In-j}(x_{Qn-j}) - \tilde{A}_{Qn-j}(x_{In-j}) \right) \right] X_n$$

$$= \tilde{A}_{Qn}\, X_n$$

$\hat{\eta}_{In}$ and $\hat{\eta}_{Qn}$ are subtracted from I and Q components of the target signal, $\eta_{In}$ and $\eta_{Qn}$, respectively, to generate error signals $\varepsilon_{In}$ and $\varepsilon_{Qn}$. The errors are fed back to update the stored coefficients. The feedback loops are similar to those of FIG. 2 and are not shown in the diagram.

2N multiplications are required to generate output term $y_{In}$ and 2N additional multiplications are required for the updates associated with the memory banks storing the coefficients for the I component. Similarly, a total of 4N multiplications are also required to generate output term $y_{Qn}$ and to update the memory banks storing the coefficients for the Q component.

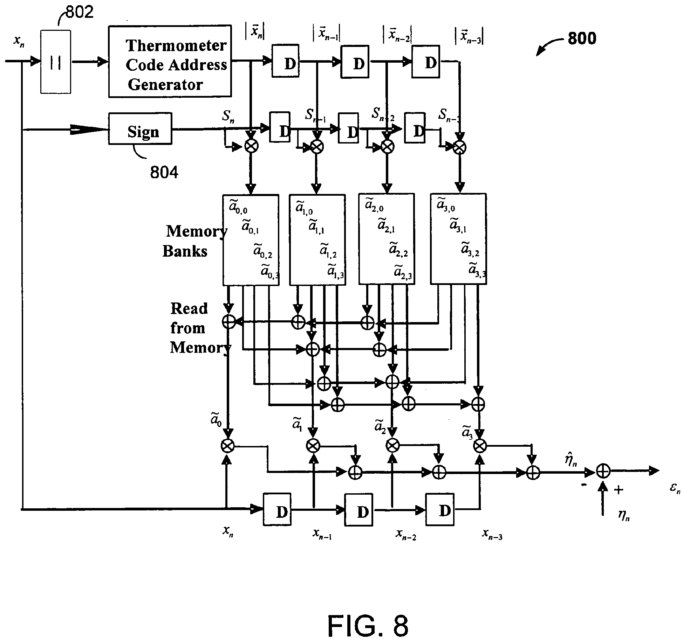

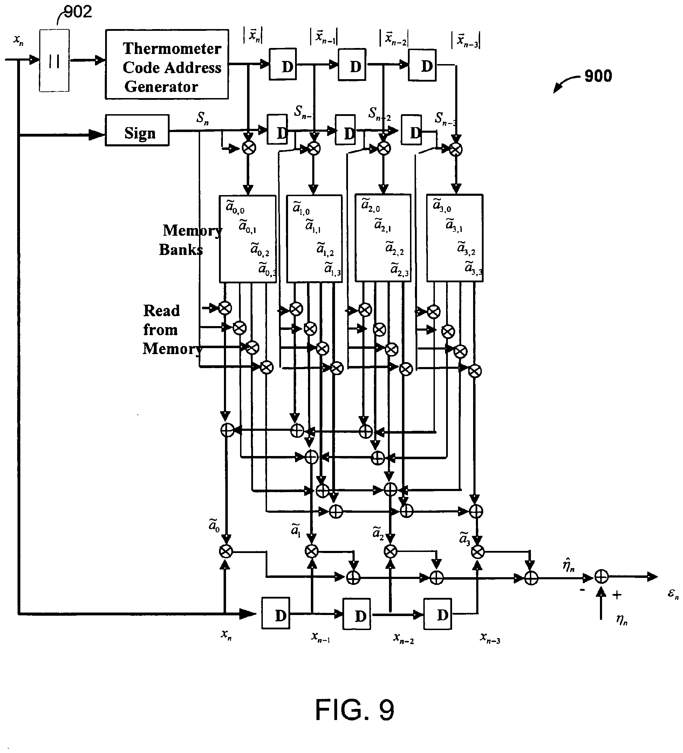

In some embodiments, the adaptive nonlinear filter is configured to handle even or odd harmonic distortions in the target signal. Whether a harmonic distortion is even or odd depends on the frequency location of the distortion relative to the desired signal, i.e. whether the distortion occurs at an even or an odd multiple of the desired frequency. FIGS. 8 and 9 are block diagrams illustrating embodiments of adaptive nonlinear filters that handle even and odd harmonic distortions, respectively. In the examples shown, filters 800 and 900 each include an absolute value operator (802 and 902, respectively) coupled to their respective input terminals. The thermometer code address generator generates an output according to the following:

$$\bar{x}_{n-j} = Sign\left( \left| x_{n-j} \right| - \bar{\beta} \right) \qquad [20]$$

Filters 800 and 900 further include sign operators 804 and 904, respectively. The sign operator extracts the sign of the input, outputting either -1 or 1. In both filter embodiments, the sign of the input is multiplied with the thermometer code address, and the multiplication result is used as the address for selecting an appropriate coefficient vector from the corresponding memory bank. Delay elements and additional memory banks are included to provide coefficients for additional filter taps. In even harmonic filter 800, selected values from the memory banks are summed to generate appropriate filter coefficients. In odd harmonic filter 900, the selected values are multiplied with their corresponding sign values before they are summed to generate the filter coefficients. The general expression for this type of N-tap filter is:

$$y_n = \left[ s_{0n}\, \tilde{A}_0\left(\left|x_n\right|\right) + s_{1n}\, \tilde{A}_1\left(\left|x_{n-1}\right|\right) + \cdots + s_{N-1n}\, \tilde{A}_{N-1}\left(\left|x_{n-N+1}\right|\right) \right] X_n$$

$$= \left[ \sum_{j=0}^{N-1} s_{jn}\, \tilde{A}_{n-j}\left(\left|x_{n-j}\right|\right) \right] X_n \qquad [21]$$

$$= \tilde{A}_n\, X_n$$

where $s_{jn} = 1$ for an even harmonic filter such as 800, and $s_{jn} = Sign\,(x_{n-j})$ for an odd harmonic filter such as 900. A converged output signal of 800 has even harmonics that are approximately equal to the even harmonics of the target signal, although its odd harmonics are not necessarily close to the odd harmonics of the target. The resulting output signal of 900 has odd harmonics that are approximately the same as the odd harmonics of the target signal, although its even harmonics are not necessarily the same as those of the target signal.

The filter coefficients are updated according to the following:

$$S_n \circ \widetilde{A}_{n+1-j} = S_n \circ \widetilde{A}_{n-j} + \mu \, \varepsilon_n \left| X_n \right| \qquad\qquad [22]$$

where

$S_n = \llcorner s_n \; s_{n-1} \cdots s_{n-N+1} \lrcorner$ and $\circ$ is the operator for element-by-element multiply.

In some embodiments, an even harmonic filter and an odd harmonic filter are combined to form a composite filter that handles both even and odd harmonics. Components such as the absolute value operator, the thermometer code address generator, and the sign operator can be shared by the odd and even filter branches.

Nonlinear adaptive filters are used in many applications. FIGS. 10A-10C are block diagrams illustrating several example applications that employ nonlinear adaptive filters. Many other systems and configurations are possible. In example systems 1000, 1030, and 1060, adaptive filter modules 1002, 1032, and 1062 may be implemented using any of the adaptive filter module embodiments described above. Modules 1002, 1032 and 1062 are coupled to nonlinear systems 1004, 1034, and 1064. The nonlinear systems can be any type of nonlinear system whose output signal $y$ is a nonlinear function of input signal $x$, for example nonlinear channels such as communication channels with channel distortion, nonlinear components such as electrical and/or optical devices (e.g., amplifiers, transceivers) that process and/or propagate the input signals, or combinations thereof. In some embodiments, one or more analog to digital converters and/or digital to analog converters are included with the nonlinear system to ensure compatibility between digital and analog components. The adaptive filter modules in the example systems and their corresponding feedback loops are configured differently depending on the functions performed.

In example system 1000 of FIG. 10A, adaptive filter module 1002 performs a modeling function to model the function of nonlinear system 1004. In this example, input $x$ of system 1004 is also sent to 1002 as the adaptive filter's input, and output y of system 1004 is sent to filter 1002 as the target signal. Adaptive filter module 1002 adapts its filter coefficients to drive its output $\hat{y}$ close to $y$, forming a filter whose filter function approximates the nonlinear function of system 1004. In other words, adaptive filter module 1002 continuously adapts its coefficients based on the feedback error signal $\varepsilon$ (which is the difference between nonlinear system 1004's output $y$ and adaptive filter module 1002's output $\hat{y}$), until the error is less than or equal to a predetermined value $\varepsilon_0$.

In example system 1030 of FIG. 10B, adaptive filter module 1032 performs post-distortion correction function to compensate for distortion previously introduced by nonlinear system 1034. The input signal of adaptive filter module 1032 is the output of system 1034, $y$. The target signal of adaptive filter module 1032 is the input to system 1034, $x$. Adaptive filter module 1032 adapts its coefficients, driving its output $\hat{x}$ close to the target signal $x$. Thus, the filter function of adaptive filter module is approximately the inverse function of nonlinear system 1034, and distortions introduced by nonlinear system 1034 are corrected.

In example system 1060 of FIG. 10C, adaptive filter module 1062 performs pre-distortion correction function to compensate for distortion that is later introduced by nonlinear system 1064. The input signal to adaptive filter module 1062 is the same as the input to the entire system, $x$. The output of the adaptive filter module is the input to nonlinear system 1064. The target signal to the adaptive filter module is the output of nonlinear system 1064, $\hat{x}$. Adaptive filter module 1062 adapts its coefficients to drive the output of nonlinear system 1064 $\hat{x}$ close to the input signal $x$. Since the filter function of adaptive filter module is approximately the inverse of nonlinear system 1064's filter function, the output signal $y$ is pre-compensated before it is sent to nonlinear system 1064, and distortions introduced by the nonlinear system are corrected.

Adaptive nonlinear filtering has been described. The technique allows nonlinear filter functions to be implemented using relatively simple elements such as memory banks and/or arithmetic operators, and has relatively inexpensive computational requirements.

Although the foregoing embodiments have been described in some detail for purposes of clarity of understanding, the invention is not limited to the details provided. There are many alternative ways of implementing the invention. The disclosed embodiments are illustrative and not restrictive.

## Claims

1. An adaptive nonlinear filtering system implementing a nonlinear filter function having N filter taps, the system comprising:

   a first interface (201) configured to receive an input signal;
   a second interface (204) configured to receive a target signal;
   an adaptive filter module including:

   a plurality of N memory banks, each corresponding to one of the N filter taps, wherein each of the memory banks stores a set of coefficient vectors that includes a plurality of S entries,
a thermometer code address generator coupled to the first interface and configured to divide a possible range of values of the input signal into S subranges, wherein the number of subranges S depends on a granularity of the nonlinear function, and
a feedback loop, both the feedback loop and thermometer code address generator coupled to the memory banks,

wherein the adaptive filter module is configured to:

generate, by the thermometer code address generator, relative location information pertaining to a relative location of a value of the input signal within said possible range, wherein the relative location information is used to select an appropriate coefficient vector from each of the memory banks;
determine an input dependent filter parameter based at least in part on the relative location information;
generate, using the appropriate coefficient vector from the memory banks, an output signal based at least in part on the input dependent filter parameter; and
feed back, by the feedback loop, a feedback signal to update the memory banks that is generated based at least in part on the output signal and the target signal.

2. The system of Claim 1, wherein the adaptive filter module is further configured to:

generate delayed relative location information pertaining to a relative location of a delayed input signal within an input range; and
wherein the input dependent filter parameter is determined further based at least in part on the delayed relative location information.

3. The system of Claim 1, wherein the input dependent filter parameter includes a filter coefficient value.

4. The system of Claim 1, wherein the adaptive filter module is further configured to:

generate delayed relative location information pertaining to a relative location of a delayed input signal within said possible range; and
wherein determining the input dependent filter parameter includes:

selecting a first value from a first one of the plurality of N memory banks using the relative location information;
selecting a second value from a second one of the plurality of N memory banks using the delayed relative location information; and
summing the first value and the second value.

5. The system of Claim 4, wherein the input dependent filter parameter includes a filter coefficient that is dependent at least in part on a sum of the first value and the second value.

6. The system of Claim 4, wherein:

the input dependent filter parameter is a first input dependent filter parameter;
determining the first input dependent filter parameter includes selecting a first function from a first one of the plurality of memory banks using the relative location information;
the adaptive filter module is further configured to:
determine a second input dependent filter parameter, including by selecting a second function from a second one of the plurality of memory banks using the delayed relative location information.

7. The system of Claim 6, wherein the output signal is generated based at least in part on a sum of the first and the second input dependent filter parameters.

8. The system of Claim 1, wherein the adaptive filter module is a first adaptive filter module, and the system further comprises a second adaptive filter module that is coupled to the first adaptive filter module in a cascaded configuration.

9. The system of Claim 1, wherein the input signal is an in-phase (I) component of a received signal.

**10.** The system of Claim 9, wherein the adaptive filter module is a first adaptive filter module configured to process the component, and the system further includes a second adaptive filter module configured in parallel with the first adaptive filter module to process a quadrature phase (Q) component of the received signal.

**11.** The system of Claim 1, wherein the adaptive filter module further includes an absolute value operator coupled to the thermometer code address generator, or a sign operator.

**12.** The system of Claim 1, wherein the output signal includes odd harmonics that arc approximately equal to the odd harmonics of the target signal, or includes even harmonics that are approximately equal to the even harmonics of the target signal.

**13.** The system of Claim 1, wherein:

the input signal is an input signal of a nonlinear system;
the target signal is an output signal of the nonlinear system; and
the adaptive nonlinear filtering system is configured to model the nonlinear system.

**14.** The system of Claim 1, wherein:

the input signal is an output signal of a nonlinear system;
the target signal is an input signal of the nonlinear system; and
the adaptive nonlinear filtering system is configured to perform post-distortion correction on the nonlinear system.

**15.** The system of Claim 1, wherein:

the output signal is an input of a nonlinear system;
the target signal is an output of the nonlinear system; and
the adaptive nonlinear filtering system is configured to perform pre-distortion correction on the nonlinear system.

**16.** An adaptive nonlinear signal processing method implementing a nonlinear filter function having N filter taps, the method comprising:

receiving an input signal and a target signal;
generating, by a thermometer code address generator, relative location information pertaining to a relative location of the input signal within an input range by dividing the input range into S subranges, wherein the number of subranges S depends on a granularity of the nonlinear function, and
wherein the relative location information is used to select an appropriate one of coefficient vectors from each of a plurality of N memory banks,
each corresponding to one of the N filter taps, wherein each of the memory bank stores a set of the coefficient vectors that includes a plurality of S entries;
determining an input dependent filter parameter based at least in part on the relative location information;
generating, using the coefficient vectors from the memory banks, an output signal based at least in part on the input dependent filter parameter; and
feeding back a feedback signal to update the memory banks that is generated based at least in part on the output signal and the target signal.

**Patentansprüche**

**1.** Adaptives nicht lineares Filtersystem, das eine nicht lineare Filterfunktion implementiert, die N Filterabgriffe hat, wobei das System aufweist:

eine erste Schnittstelle (201), die dazu konfiguriert ist, ein Eingangssignal zu empfangen;
eine zweite Schnittstelle (204), die dazu konfiguriert ist, ein Zielsignal zu empfangen;
ein adaptives Filtermodul, das aufweist:

eine Vielzahl von N Speicherbänken, die jeweils einem der N Filterabgriffe entsprechen, wobei jede der Speicherbänke einen Satz von Koeffizientenvektoren speichert, der eine Vielzahl von S Einträgen aufweist,

einen Thermometer-Codeadressen-Generator, der mit der ersten Schnittstelle verbunden und dazu konfiguriert ist, einen möglichen Bereich von Werten des Eingangssignals in S Unterbereiche zu teilen, wobei die Anzahl der Unterbereiche S von der Granularität der nicht linearen Funktion abhängt, und eine Rückkopplungsschleife, wobei sowohl die Rückkopplungsschleife als auch der Thermometer-Codeadressen-Generator mit den Speicherbänken verbunden sind,

wobei das adaptive Filtermodul konfiguriert ist zum:

Erzeugen, durch den Thermometer-Codeadressen-Generator, von relativen Ortsangaben, die zu einem relativen Ort eines Werts des Eingangssignals in dem möglichen Bereich gehören, wobei die relativen Ortsangaben verwendet werden, um einen geeigneten Koeffizientenvektor aus jeder der Speicherbänke auszuwählen;
Bestimmen eines eingangsabhängigen Filterparameters basierend wenigstens teilweise auf den relativen Ortsangaben;
Erzeugen, unter Verwendung des geeigneten Koeffizientenvektors aus den Speicherbänken, eines Ausgangssignals basierend wenigstens teilweise auf dem eingangsabhängigen Filterparameter; und
Rückkoppeln, durch die Rückkopplungsschleife, eines Rückkopplungssignals zum Aktualisieren der Speicherbänke, das wenigstens teilweise basierend auf dem Ausgangssignal und dem Zielsignal erzeugt wird.

2. System nach Anspruch 1, wobei das adaptive Filtermodul des Weiteren konfiguriert ist zum:

Erzeugen verzögerter relativer Ortsangaben, die zu einem relativen Ort eines verzögerten Eingangssignals in einem Eingangsbereich gehören; und
wobei der eingangsabhängige Filterparameter des Weiteren basierend wenigstens teilweise auf den verzögerten relativen Ortsangaben bestimmt wird.

3. System nach Anspruch 1, wobei der eingangsabhängige Filterparameter einen Filterkoeffizientenwert aufweist.

4. System nach Anspruch 1, wobei das adaptive Filtermodul des Weiteren konfiguriert ist zum:

Erzeugen verzögerter relativer Ortsangaben, die zu einem relativen Ort eines verzögerten Eingangssignals in dem möglichen Bereich gehören; und
wobei das Bestimmen des eingangsabhängigen Filterparameters aufweist:

Auswählen eines ersten Werts aus einer ersten der Vielzahl von N Speicherbänken unter Verwendung der relativen Ortsangaben;
Auswählen eines zweiten Werts aus einer zweiten der Vielzahl von N Speicherbänken unter Verwendung der verzögerten relativen Ortsangaben; und
Addieren des ersten Werts mit dem zweiten Wert.

5. System nach Anspruch 4, wobei der eingangsabhängige Filterparameter einen Filterkoeffizienten aufweist, der wenigstens teilweise von einer Summe des ersten Werts und des zweiten Werts abhängig ist.

6. System nach Anspruch 4, wobei:

der eingangsabhängige Filterparameter ein erster eingangsabhängiger Filterparameter ist;
das Bestimmen des ersten eingangsabhängigen Filterparameters das Auswählen einer ersten Funktion aus einer ersten der Vielzahl von Speicherbänken unter Verwendung der relativen Ortsangaben aufweist;
das adaptive Filtermodul des Weiteren konfiguriert ist zum:
Bestimmen eines zweiten eingangsabhängigen Filterparameters, das das Auswählen einer zweiten Funktion aus einer zweiten der Vielzahl von Speicherbänken unter Verwendung der verzögerten relativen Ortsangaben aufweist.

7. System nach Anspruch 6, wobei das Ausgangssignal basierend wenigstens teilweise auf einer Summe der ersten und zweiten eingangsabhängigen Filterparameter erzeugt wird.

8. System nach Anspruch 1, wobei das adaptive Filtermodul ein erstes adaptives Filtermodul ist und das System des Weiteren ein zweites adaptives Filtermodul aufweist, das in einer kaskadierten Konfiguration mit dem ersten adaptiven Filtermodul verbunden ist.

9. System nach Anspruch 1, wobei das Eingangssignal eine gleichphasige (I) Komponente eines empfangenen Signals ist.

10. System nach Anspruch 9, wobei das adaptive Filtermodul ein erstes adaptives Filtermodul ist, das dazu konfiguriert ist, die I-Komponente zu verarbeiten, und das System des Weiteren ein zweites adaptives Filtermodul aufweist, das parallel zu dem ersten adaptiven Filtermodul konfiguriert ist, um eine Quadraturphasen (Q) -Komponente des empfangenen Signals zu verarbeiten.

11. System nach Anspruch 1, wobei das adaptive Filtermodul des Weiteren einen Absolutwertoperator aufweist, der mit dem Thermometer-Codeadressen-Generator verbunden ist, oder einen Vorzeichenoperator.

12. System nach Anspruch 1, wobei das Ausgangssignal ungeradzahlige Harmonische aufweist, die mit den ungeradzahligen Harmonischen des Zielsignals in etwa gleich sind, oder geradzahlige Harmonische aufweist, die mit den geradzahligen Harmonischen des Zielsignals in etwa gleich sind.

13. System nach Anspruch 1, wobei:

das Eingangssignal ein Eingangssignal eines nicht linearen Systems ist;
das Zielsignal ein Ausgangssignal des nicht linearen Systems ist; und
das adaptive nicht lineare Filtersystem dazu konfiguriert ist, das nicht lineare System zu modellieren.

14. System nach Anspruch 1, wobei:

das Eingangssignal ein Ausgangssignal eines nicht linearen Systems ist;
das Zielsignal ein Eingangssignal des nicht linearen Systems ist; und
das adaptive nicht lineare Filtersystem dazu konfiguriert ist, Post-Störkorrektur für das nicht lineare System durchzuführen.

15. System nach Anspruch 1, wobei:

das Ausgangssignal ein Eingang eines nicht linearen Systems ist;
das Zielsignal ein Ausgang des nicht linearen Systems ist; und
das adaptive nicht lineare Filtersystem dazu konfiguriert ist, Prä-Störkorrektur für das nicht lineare System durchzuführen.

16. Adaptives nicht lineares Signalverarbeitungsverfahren, das eine nicht lineare Filterfunktion implementiert, die N Filterabgriffe hat, wobei das Verfahren umfasst:

Empfangen eines Eingangssignals und eines Zielsignals;
Erzeugen, durch einen Thermometer-Codeadressen-Generator, von relativen Ortsangaben, die zu einem relativen Ort des Eingangssignals in einem Eingangsbereich gehören, durch Teilen des Eingangsbereichs in S Unterbereiche, wobei die Anzahl von Unterbereichen S von der Granularität der nicht linearen Funktion abhängt, und
wobei die relativen Ortsangaben verwendet werden, um einen geeigneten Koeffizientenvektor aus jeder einer Vielzahl von N Speicherbänken auszuwählen, wobei jede einem der N Filterabgriffe entspricht, wobei jede der Speicherbänke einen Satz der Koeffizientenvektoren speichert, der eine Vielzahl von S Einträgen aufweist;
Bestimmen eines eingangsabhängigen Filterparameters basierend wenigstens teilweise auf den relativen Ortsangaben;
Erzeugen, unter Verwendung der Koeffizientenvektoren aus den Speicherbänken, eines Ausgangssignals basierend wenigstens teilweise auf dem eingangsabhängigen Filterparameter; und
Rückkoppeln eines Rückkopplungssignals zum Aktualisieren der Speicherbänke, das wenigstens teilweise auf dem Ausgangssignal und dem Zielsignal basiert.

**Revendications**

1. Système de filtrage non linéaire adaptatif mettant en œuvre une fonction de filtre non linéaire ayant N prises de filtres, le système comprenant :

   une première interface (201) conçue pour recevoir un signal d'entrée ;
   une seconde interface (204) conçue pour recevoir un signal cible ;
   un module de filtre adaptatif comprenant :

   une pluralité de N banques de mémoire, chacune correspondant à une des N prises de filtres, chacune des banques de mémoire stockant un ensemble de vecteurs de coefficients qui comprend une pluralité de S entrées,
   un générateur d'adresses de code de thermomètre couplé à la première interface et conçu pour diviser une plage possible de valeurs du signal d'entrée en S sous-plages, le nombre de S sous-plages dépendant d'une granularité de la fonction non linéaire, et
   une boucle de rétroaction, la boucle de rétroaction et le générateur d'adresses de code de thermomètre sont tous les deux couplés aux banques de mémoire,

   le module de filtre adaptatif étant conçu pour :

   générer, par le générateur d'adresses de code de thermomètre, des informations de localisation relatives appartenant à une localisation relative d'une valeur du signal d'entrée au sein de ladite plage possible, les informations de localisation relatives étant utilisées pour sélectionner un vecteur de coefficient approprié à partir de chacune des banques de mémoire ;
   déterminer un paramètre de filtre dépendant de l'entrée basé au moins en partie sur les informations de localisation relatives ;
   générer, à l'aide du vecteur de coefficient approprié à partir des banques de mémoire, un signal de sortie basé au moins en partie sur le paramètre de filtre dépendant de l'entrée ; et
   retourner, par la boucle de rétroaction, un signal de rétroaction, en vue de mettre à jour les banques de mémoire, qui est généré sur la base, au moins en partie, du signal de sortie et du signal cible.

2. Système selon la revendication 1, dans lequel le module de filtre adaptatif est conçu en outre pour :

   générer des informations de localisation relatives retardées appartenant à une localisation relative d'un signal d'entrée retardé dans une plage d'entrée ; et
   dans lequel le paramètre de filtre dépendant de l'entrée est déterminé sur la base en outre au moins en partie des informations de localisation relatives retardées.

3. Système selon la revendication 1, dans lequel le paramètre de filtre dépendant de l'entrée comprend une valeur de coefficient de filtre.

4. Système selon la revendication 1, dans lequel le module de filtre adaptatif est conçu en outre pour :

   générer des informations de localisation relatives retardées appartenant à une localisation relative d'un signal d'entrée retardé dans ladite plage possible ; et
   dans lequel déterminer le paramètre de filtre dépendant de l'entrée comprend :

   la sélection d'une première valeur à partir d'une première de la pluralité des N banques de mémoire à l'aide des informations de localisation relatives ;
   la sélection d'une seconde valeur à partir d'une seconde de la pluralité des N banques de mémoire à l'aide des informations de localisation relatives retardées ; et
   l'ajout de la première valeur et de la seconde valeur.

5. Système selon la revendication 4, dans lequel le paramètre de filtre dépendant de l'entrée comprend un coefficient de filtre qui dépend au moins en partie d'une somme de la première valeur et de la seconde valeur.

6. Système selon la revendication 4, dans lequel :

le paramètre de filtre dépendant de l'entrée est un premier paramètre de filtre dépendant de l'entrée ; la détermination du premier paramètre de filtre dépendant de l'entrée comprend la sélection d'une première fonction à partir d'une première de la pluralité de banques de mémoire à l'aide des informations de localisation relatives ;

le module de filtre adaptatif est conçu en outre pour :

déterminer un second paramètre de filtre dépendant de l'entrée, y compris en sélectionnant une seconde fonction à partir d'une seconde de la pluralité de banques de mémoire à l'aide des informations de localisation relatives retardées.

7.  Système selon la revendication 6, dans lequel le signal de sortie est généré sur la base au moins en partie d'une somme des premier et second paramètres de filtre dépendant de l'entrée.

8.  Système selon la revendication 1, dans lequel le module de filtre adaptatif est un premier module de filtre adaptatif, et le système comprend en outre un second module de filtre adaptatif qui est couplé au premier module de filtre adaptatif dans une configuration en cascade.

9.  Système selon la revendication 1, dans lequel le signal d'entrée est une composante en phase (I) d'un signal reçu.

10. Système selon la revendication 9, dans lequel le module de filtre adaptatif est un premier module de filtre adaptatif conçu pour traiter le composant I, et le système comprend en outre un second module de filtre adaptatif conçu en parallèle avec le premier module de filtre adaptatif pour traiter une composante de phase en quadrature (Q) du signal reçu.

11. Système selon la revendication 1, dans lequel le module de filtre adaptatif comprend en outre un opérateur de valeur absolue couplé au générateur d'adresses de code de thermomètre, ou un opérateur de signe.

12. Système selon la revendication 1, dans lequel le signal de sortie comprend des harmoniques impaires qui sont approximativement égales aux harmoniques impaires du signal cible, ou comprend des harmoniques paires qui sont approximativement égales aux harmoniques paires du signal cible.

13. Système selon la revendication 1, dans lequel :

le signal d'entrée est un signal d'entrée d'un système non linéaire ;
le signal cible est un signal de sortie du système non linéaire ; et
le système de filtrage non linéaire adaptatif est conçu pour modéliser le système non linéaire.

14. Système selon la revendication 1, dans lequel :

le signal d'entrée est un signal de sortie d'un système non linéaire ;
le signal cible est un signal d'entrée du système non linéaire ; et
le système de filtrage non linéaire adaptatif est conçu pour exécuter une correction post-distorsion sur le système non linéaire.

15. Système selon la revendication 1, dans lequel :

le signal de sortie est une entrée d'un système non linéaire ;
le signal cible est une sortie du système non linéaire ; et
le système de filtrage non linéaire adaptatif est conçu pour exécuter une correction de pré-distorsion sur le système non linéaire.

16. Procédé de traitement de signal non linéaire adaptatif mettant en œuvre une fonction de filtre non linéaire ayant N prises de filtres, le procédé comprenant :

la réception d'un signal d'entrée et d'un signal cible ;
la génération, par un générateur d'adresses de code de thermomètre, d'informations de localisation relatives appartenant à une localisation relative du signal d'entrée dans une plage d'entrée en divisant la plage d'entrée en S sous-plages, le nombre de S sous-plages dépendant d'une granularité de la fonction non linéaire, et les informations de localisation relatives étant utilisées pour sélectionner un vecteur approprié parmi des vecteurs de coefficients à partir de chaque banque d'une pluralité de N banques de mémoire, chacune correspondant à une des N prises de filtres, chaque banque de mémoire stockant un ensemble de vecteurs de coefficients qui comprend une pluralité de S entrées ;

la détermination d'un paramètre de filtre dépendant de l'entrée basée au moins en partie sur les informations de localisation relatives ;

la génération, à l'aide des vecteurs de coefficients à partir des banques de mémoire, d'un signal de sortie basé au moins en partie sur le paramètre de filtre dépendant de l'entrée ; et

le retour d'un signal de rétroaction, en vue de mettre à jour les banques de mémoire, qui est généré sur la base, au moins en partie, du signal de sortie et du signal cible.

FIG. 1A

FIG. 1B

FIG. 1C

FIG. 2

FIG. 3

FIG. 4A

$x_n = 1.2,$          $x_{n-1} = 0.7,$          $x_{n-2} = 2.9,$          $x_{n-3} = -0.5,$
$\vec{x}_n = [-1 -1 +1 +1]$     $\vec{x}_{n-1} = [-1 +1 +1 +1]$     $\vec{x}_{n-2} = [-1 -1 -1 +1]$     $\vec{x}_{n-3} = [+1 +1 +1 +1]$

$[\beta_{min}, \beta_0] = [-1, 0]$

$(\beta_0, \beta_1] = (0, 1]$

$(\beta_1, \beta_2] = (1, 2]$

$(\beta_2, \beta_{max}] = (2, 3]$

FIG. 4B

500

502

Receive an input signal and a target signal

504

Generate relative location information

506

Determine one or more input dependent filter parameters using the relative location information

508

Generate an output signal using the input dependent filter parameter

510

Feeding back a feedback signal that is generated using the output signal and the target signal

FIG. 5

FIG. 6

FIG. 7

FIG. 8

FIG. 9

1004

Nonlinear
system

X

y

+

ε

-

ŷ

1000

Adaptive
filter module

1002

## FIG. 10A

1034

X

Nonlinear
system

y

Adaptive
filter module

1032

x̂

1030

ε

+  -

## FIG. 10B

1060

X

Adaptive
filter module

1062

y

Nonlinear
system

1064

x̂

ε

-  +

## FIG. 10C

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 99805707
- US 2005201457 A1